Europäisches Patentamt

European Patent Office

Office européen des brevets

(19)

(11) Publication number: **0 142 176**
A1

(12) **EUROPEAN PATENT APPLICATION**

(21) Application number: **84200311.3**

(22) Date of filing: **06.03.84**

(51) Int. Cl.⁴: **C 23 C 16/26**
**//C01B31/02**

(30) Priority: **24.10.83 US 544784**

(43) Date of publication of application:
**22.05.85 Bulletin 85/21**

(84) Designated Contracting States:
**AT BE CH DE FR GB IT LI LU NL SE**

(71) Applicant: **Merkl, George Gergely**
**2413 Bayshore Bv. 205**
**Tampa Florida 33609(US)**

(72) Inventor: **Merkl, George Gergely**
**2413 Bayshore Bv. 205**
**Tampa Florida 33609(US)**

(74) Representative: **Donné, Eddy**
**M.F.J.Bockstael Arenbergstraat 13**
**B-2000 Anvers(BE)**

(54) **Cubic carbon.**

(57) Disclosed is a crystalline face centred allotrope of carbon having properties of extreme hardness, inertness and a negative thermal coefficient of resistance. The crystalline carbon may be adherently deposited onto a substrate by decomposition a hydrocarbon gas into constituent gaseous ionic hydrogen and carbon fractions, separating the fractions into layers, and exposing the objects desired to be coated to the carbon layer whereon deposition occurs. The properties of the crystalline carbon, termed cubic carbon, may be varied by suitably doping with a known amount of a known impurity.

EP 0 142 176 A1

"Cubic carbon"

This invention relates to a novel carbon allotrope and to coatings thereof possessing a combination of properties heretofore unknown, which allotrope will hereinafter be referred to as "cubic carbon".

The coating art is replete with myriad compositions suited to a wide spectrum of uses. Utilities of coatings are bottomed on needs ranging from those that are cosmetic-protective (e.g. paints, varnishes, and lacquers) to those that are principally protective (e.g. zinc galvanic coatings) to those which must be able to withstand the most rigorous of physical and chemical conditions (e.g. high temperature wire enamels,acid or caustic container coatings, high temperature oxidation-resistant coatings). As a generally proposition, most coating materials in use today are polymeric in nature, with some obvious exceptions such as galvanic zinc coatings. Other than the latter, however, there are few if any examples of common protective coatings which are applied in elemental form.

It has long been suspected that there exists a form of carbon intermediate between graphite and diamond. Graphite and diamond represent carbon allotropes i.e. the same elemental substance existing in two or more forms which manifest extremely diverse physical and/or chemical properties. Diamond is formed of a tetrahedral network lattice structure in which each carbon atom is tetrahedrally bonded to four other carbon atoms through SP hybrid orbitals.Because of this network bonding arrangement, diamond is essentially a super crystal which accordingly exhibits extreme hardness, a high melting point, great chemical stability, and non-conduction of electricity due to the fact that all electrons are covalently bound and therefore unavailable to function as charge carriers. By contrast, graphite is composed of layers of fused hexagonal rings, which layers are bonded to each other by relatively weak van der Waal's forces. Because of these weak forces, facile slippage of the layers over each other occurs, resulting in the characteristic lubricity which graphit exhibits. Other amphorous forms of carbon such as carbon black also exist.

Some attempts have been made to locate a carbon allotrope intermediate between graphite and diamond, but none have met with success. Such an allotrope has now been discovered, along with a method for its manufacture.

The present invention provides a novel allotrope of carbon having a face centered cubic structure. As will herein be described, this allotrope possesses a wide spectrum of properties, the combination of which is not exhibited by any prior art coating.

Cubic carbon is formed by the decomposition of a hydrocarbon gas at high temperature and under otherwise substantially quiescent conditions. By this invention, the hydrocarbon gas is admitted to a decomposition chamber where it virtually instantaneously dissociates into carbon and hydrogen ions. Because the dissociated species are in ionic form, they may be separated into layers by deflecting through a magnetic field. The separated layers of hydrogen ions and carbon ions pass into a uniformly heated deposition chamber containing objects to be coated.

Advantageously, the hydrogen ions recombine to form hydrogen gas which is vented from the chamber while the carbon ions deposit on objects in crystalline layers which have been determined to have a face-centered cubic structure.

Cubic carbon is characterized by a novel combination of properties including extreme mechanical ruggedness, a negative thermal coefficient of resistance, conductive properties which can be varied or manipulated, efficient heat transfer properties, complete inertness to all known chemical corrosives, and high temperature oxidative stability. Cubic carbon therefore possesses a wide spectrum of applications ranging from coatings which prolong the useful life of tungsten-carbide cutting tools by a factor of 2 to 5, to utility in forming junction devices such as solar cells which transduce sunlight into electrical energy. This carbon allotrope additionally finds utility in more mundane settings such as forming resistant coatings on cooking vessels which, when suitably provided with electrical leads, have the capability of heating comestibles using the whole of the coated surface at a fraction of the cost required to cook on a conventional gas or electric range burner.

Prior art attempts to make the novel cubic carbon allotrope of this invention have failed chiefly for two reasons. First, in any reactor wherein a hydrocarbon gas is decomposed to constituent hydrogen and carbon ions, it is important that mass convection be avoided. Therefore, the flow rate at which a hydrocarbon gas is permitted to travel through the apparatus must be carefully controlled and maintained at a level low enough so that no such convection occurs. Thus, the term "substantially quiescent" used previously means any flow rate which does not cause mass convection to occur. The apparatus used to effect decomposition of a hydrocarbon vapor is constructed such that the hydrogen and carbon separate into ionic layers.

Thus, it is easily seen that any hydrocarbon decomposition apparatus of a given size or volume will be characterized by a critical flow rate which may not be exceeded without causing recombination or mixing of said layers, which in turn would be fatal to the formation of cubic carbon.

The second important point is that thermal convection of the separated carbon and hydrogen layers should be avoided, and therefore uniform heating of the entire decomposition chamber is required at the high decomposition temperatures employed.

To summarize, a very pure hydrocarbon gas is admitted to a high temperature uniformly heated decomposition chamber at a flow rate which avoids mass convection. The vapor decomposes into constituent hydrogen and carbon ions and these are magnetically manipulated such that a distinct layer of hydrogen ions is formed in the top of the reactor and a layer of carbon ions is formed in the bottom of the reactor. In this manner objects which have been placed in the bottom of the reactor are coated with a layer of carbon which bonds tightly thereto as a face-centered cubic crystal.

Figure 1 is a schematic diagram of the apparatus used to decompose hydrocarbon gas and deposit cubic carbon onto objects.

Figure 2 is an x-ray diffraction pattern characteristic of cubic carbon.

Figures 3-5 are electron micrographs showing the visual surface structure of a substrate not coated with cubic carbon.

Figures 6-9 are electron micrographs of a cubic carbon coated substrate at the magnifications noted.

Figure 10 is an electron micrograph of a cubic carbon coating after having been subjected to corrosion testing.

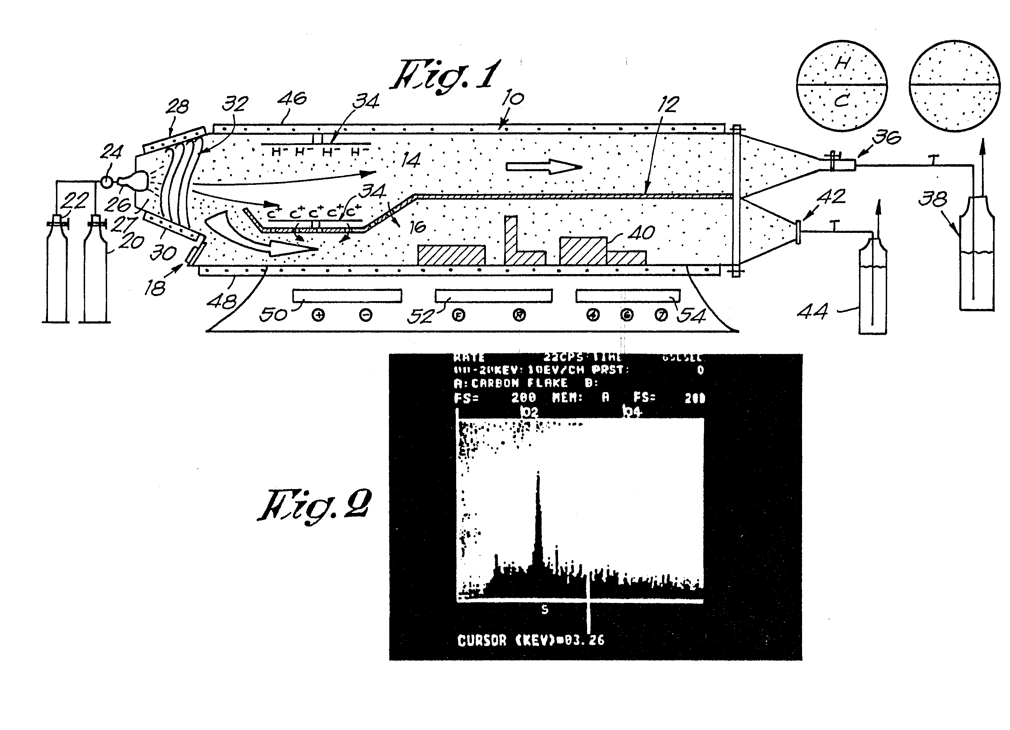

Referring to the figures, figure 1 shows the apparatus (herein also referred to as a vapor ionizer or ionizer) used for decomposing a gaseous hydrocarbon into its constituent ions such that carbon is adherently deposited on an object in a face centered cubic crystal structure. The apparatus, generally indicated as 10, comprises a first stage decomposition and separation chamber in combination with a second stage deposition chamber, which apparatus is fabricated of refractory or other high temperature material. The deposition chamber is internally divided by refractory separator 12 into upper level 14 and lower level 16 into which objects to be coated are placed through loading door 18. The chamber is initially purged of oxidative or other non-hydrocarbon material by source 20 of pure inert gas such as a tank of high-purity compressed helium. After the chamber has been purged the inert gas is shut off and the chamber is opened to source 22 of pure hydrocarbon feed gas, such as a tank of high purity compressed methane. Means for switching between the purge and feed gas may be easily effected by any conventional valve configuration. The hydrocarbon feed gas is regulated by means of flow meter 24 at a precise flow rate, the gas entering porous frit element 26 such that the gas flow is diffused so that no mass convection occurs. The gas exiting the frit immediately enters decomposition chamber 27 which is uniformly heated by means of upper heater 28 and lower heater 30. The temperature of decomposition chamber 27 is such that the gas is virtually instantaneously decomposed into carbon and hydrogen ionic species. The ions travel through a magnetic ion separator 32 which has been preset to a magnetic field strenght such that the ionic species entering the field emerge separated into two ionic layers, the upper layer being positive and negative hydrogen ions and the lower layer comprising different ionic carbon species. The lighter hydrogen ion species pass into upper level 14 of the deposition chamber while the heavier ionic carbon species are deflected into lower level 16 of said deposition chamber, the layers being maintained separate by the aforementioned refractory separator 12. The hydrogen ions in the upper level pass through a set of discharge plates 34 which promote the uniform recombination of said species to hydrogen gas which exits the upper level at 36 through a pinch valve and is bubbled through water trap 38. The carbon layer in lower level 16 adherently deposits on objects 40 which have been placed therein and forms a black metallically sheened layer thereon. Any carbon ionic species which is not so deposited exists from lower level 16 through orifice 42 and travels into water trap 44 wherein it forms carbon black. Both upper chamber 14 and lower chamber 16 are uniformly heated by means of upper heater 46 and lower heater 48. The apparatus incorporates suitable means for controlling the plate voltages 50, the magnetic field strength for separating ions 52, and for controlling temperature 54.

Any suitable object may serve as a substrate for the deposition of cubic carbon, the only requirement being that it be small enough to be placed within the deposition chamber and that it withstand the temperatures at which deposition takes place. Thus the object will generally be fabricated of metal or some suitable ceramic. Cubican carbon can be deposited on any article so long as it satisfies these requirements, and any attempt to detail a list of such objects would be meaningless.

The feed gas which serves as a source of carbon is advantageously a light hydrocarbon such as methane, ethane, propane, butane, pentane, or branched isomers thereof, although the aforesaid list is by no means meant to be exhaustive or limiting. Preferred are hydrocarbon gases having one to six carbon atoms, particularly methane.
To deposit a layer of pure crystalline cubic carbon, the

0142176

only restrictions which need be observed are that the gas be a true hydrocarbon, that the gas be of very high purity, and that the gas exhibit a vapor pressure high enough to be regulated by means of conventionally employed flow metering devices. Thus, a hydrocarbon having an extremely high vapor pressure which is yet liquid at room temperature, such as isopentane, would be suitable for use with this invention. By the term "high purity" it is meant that the gas have a purity of at least 99.9 mole percent.

It is noted that high purity gases are required only if high purity coatings of cubic carbon are desired. As it will be shown, for certain applications it is advantageous to in fact include impurities as part of the feed gas. Moreover, if the apparatus is constructed without gas metering devices such that a gas cannot be used, heavier hydrocarbons such as oil, gasoline, benzene etc. can be used by being contained e.g. in a ceramic or other high temperature container and placed within the apparatus prior to heating. The means used to heat the deposition chamber can suitably be an induction furnace which satisfies the requirement of heating the chambers evenly.

For decomposition it has been found advantageous to use temperatures in the range of 900°C to 2400°C. For temperatures up to 1400°C the vapor ionizer may be fabricated of quartz. At higher temperatures up to those not exceeding 2000°C the ionizer may be fabricated of alumina. For still higher temperatures the ionizer may be fabricated of zircon up to temperatures of 2600°C. The material most preferred for use at lower temperature is clear quartz because, advantageously, one may then view the physical processes occurring in the apparatus.

As previously mentioned, precise control of flow rate at a sufficiently low value to prevent mass convention is fairly important. Admission of the feed gas at a rate above a critical flow rate characteristic of a given apparatus having a set volume results in mixing and recombination of the decomposed gaseous constituents such that no deposition of cubic carbon will occur. For the cylindrical quartz tube employed in the experiments leading to this invention, which tube had a diameter of about 2 inches, a flow rate of about 70 cc/min. of methane gas was found to be critical.

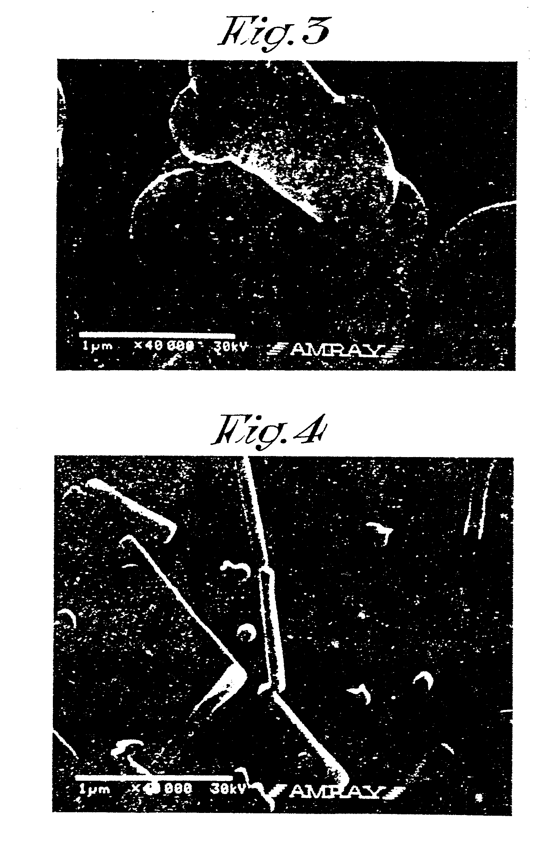

As shown by Figure 2, pure (i.e. undoped) cubic carbon exhibits an X-ray diffraction pattern which is quite distinctive and which shows a single, well defined peak rising above the background, the single peak being indicative of the single-crystal nature of the pure material. Figure 2 is intended then to represent pure cubic carbon and serves as a label by which one of ordinary skill may determine that he has in fact achieved the substance. The X-ray diffraction pattern shows the film to be a mixture of amorphous and crystalline carbon that has a distinct preferred orientation to its diffraction pattern. This orientation is no doubt due to the way the film is deposited on the substrate. The spectrographic analysis showed Ti and Si and other elements that were suspected to be due to the substrate composition and not the cubic carbon film itself. The X-ray diffraction pattern further indicates that the crystal structure is face-centered cubic.

As each crystalline material has a unique X-ray diffraction pattern, comparison of the X-ray diffraction pattern of an unknown material with the X-ray diffraction pattern for known materials permits qualitative identification of the unknown material. Since cubic carbon possesses unique X-ray diffraction pattern use of this technique permits positive identification of cubic carbon and rea-

**0142176**

dily distinguishes it from other forms of carbon.

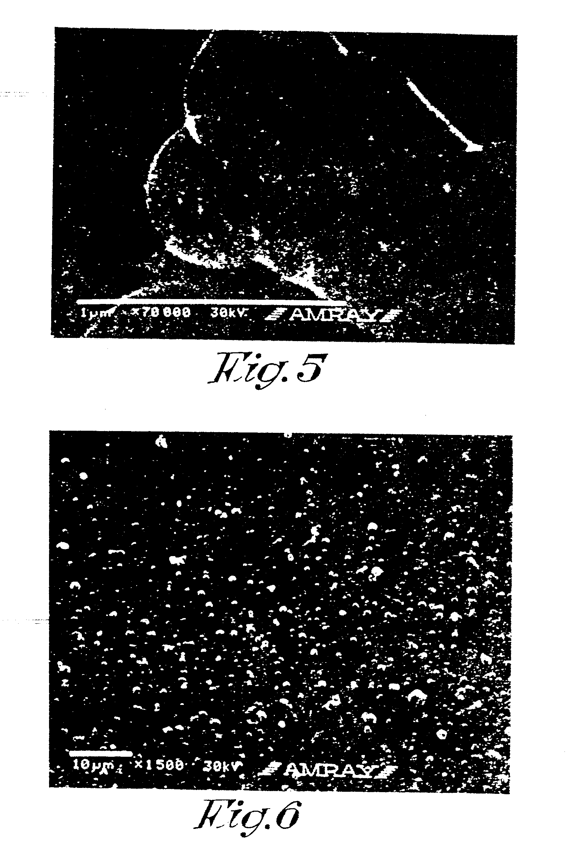

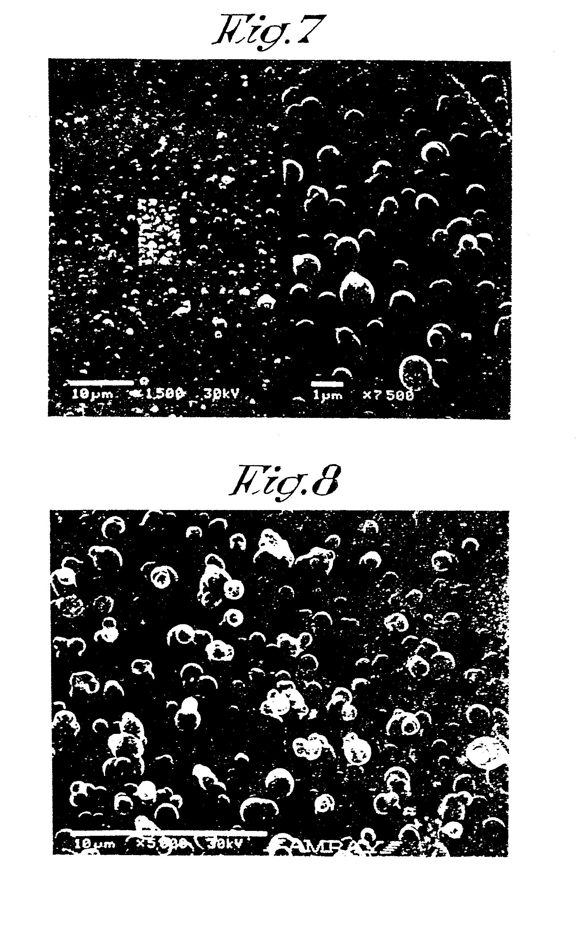

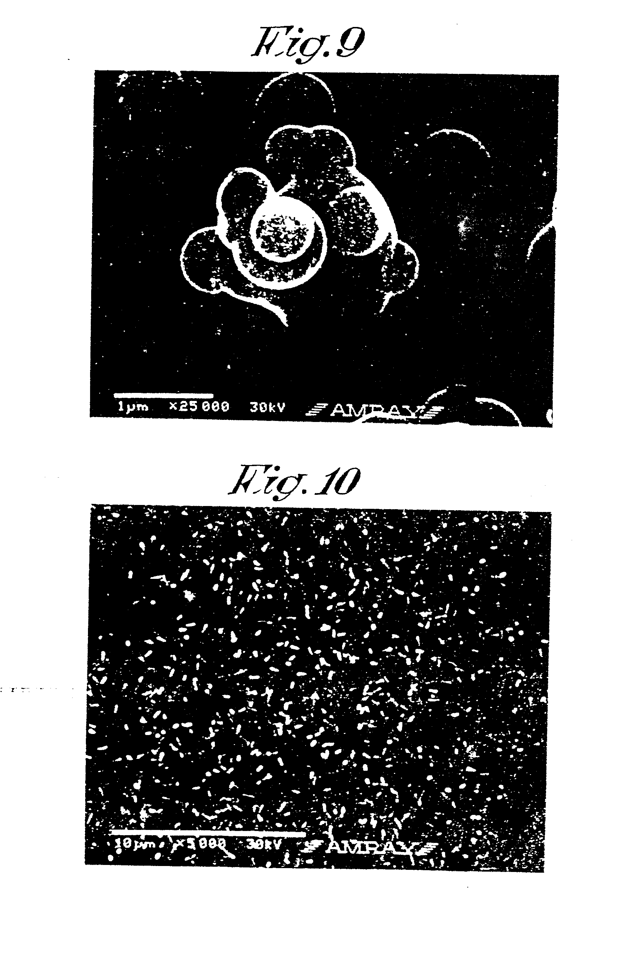

Figures 3-5 show the highly magnified surface of a substrate (quartz) which had not been coated with cubic carbon. As can be seen from these electron micrographs, no ordered structure can be seen although the surface can be seen to exhibit definitely shaped constituent particles, as shown in progressively pronounced fashion as the magnification increases from 40.000 (figures 3 and 4) to 70.000 (figure 5).

Figures 6-9 show the changing appearance of the substrate of figures 3-5 once a layer of cubic carbon has been adherently deposited thereon. As can be seen at the lower magnification (1500X) of figure 6 the coating appears homogeneous and well defined as small spheres. Figure 7 additionally shows the coating at low (1500X) magnification, but wherein the highlighted (lightened) section has been further magnified up to 7500X and shown as the right hand portion of the micrograph. In this enlargement the spherical and homogeneous nature of the single crystal structure shows up even more clearly. Figure 8 shows magnification of the surface of 5000X while figure 9 shows extreme magnification to 25000X and offers what amounts to a close look at the single crystal spherical shape of cubic carbon particles. Thus figures 6-9 offer a continuum of magnifications of a cubic carbon coating and detail the microscopic characteristics of this substance.

The chief characteristics of pure cubic carbon are its extreme hardness and inertness as displayed, for example, by its virtual total lack of response to oxidation and corrosion by any acid, base, or gas at temperatures up to 600°C. Figure 10 is an electron micrograph of crystalline cubic carbon deposited on tungsten after having been subjected to corrosion testing. There is no visual change in the micrograph from that which would be obtained for freshly deposited cubic carbon;

Cubic carbon additionally has a wide range of uses. Its diamond-like hardness extends the life of tungsten-carbide cutting tools by a factor of about 3 when deposited thereon in a thickness of about 0.1 microns. Its extreme inertness allows virtually total protection of objects used in caustic/oxidizing/acidic and generally corrosive environments such as that found in acid generators or electrolysis cells. For such debilitating environments expensive relatively inert metals used normally such as titanium to fabricate e.g. acid containers can be replaced by cubic carbon-coated aluminium (or other relatively cheap material) which is even more inert and which can be produced at a fraction of the cost.

Moreover, cubic carbon can be used to make very inexpensive junction devices which function as solar cells. A ceramic element, such as a porcelain bar is allowed to be coated to a depth of a couple of microns (ca. less than 10) with cubic carbon as described previously for the reactor. The bar so coated is then plated on its ends with two different metals, e.g; copper at one end and nickel at the other, but leaving the middle portion of the bar coated only with cubic carbon. By suitably attaching electrical leads to the copper and nickel end portions and connecting an ammeter to the leads a current will be seen to flow when the bar is exposed to sunlight ortoradiation (heat). Thus the bar so coated operates as a junction device which transduces sunlight or heat to electrical energy.

Much energy is wasted, for example, in normal cooking operations because heat from the gas burner or electric range element is dissipated into the surrounding atmos-

0142176

phere. Too, generally high power levels must be applied only to the bottom of a cooking vessel to achieve relatively lower cooking temperature therein. By coating a cooking vessel, e.g. a ceramic or high temperature glass dish which one normally places in an oven, with cubic carbon (1-5 microns) and attaching suitable electrical leads to allow connection to an ordinary wall outlet, the cubic carbon coating dissipates the electrical energy quickly and transduces it to heat over the whole surface of the vessel. Thus by simply coating the cooking surface of a cooking vessel with cubic carbon and attaching to a wall outlet, the coated dish will quickly reach a constant temperature determined by the resistance of the coating, which resistance in turn depends on the thickness of the coating and whether it has been doped with any impurities which facilitate heat transfer through the coating. No high power levels are required or oven-type environments which waste heat by heating the surrounding air space as well as the vessel itself.

In this regard cubic carbon may be intentionally doped with elements which result in the formation of carbides which affect (i.e. facilitate) the electrical conductivity by disrupting the pure cubic carbon crystal structure with molecules which transform a non-conductive material into a semi-conductive one. Such impurities are metals (e.g. aluminium, magnesium, beryllium, calcium, aluminium etc.) or other substances such as sulfur or nitrogene. The doping materials may be incorporated by being included as part of the initial hydrocarbon gas used to form the coating (if the impurities are themselves gaseous) or may be added to the decomposition chamber in a pre-calculated amount (i.e. an amount which has been empirically determined to produce a desired level of doping) wherein the impurity vaporizes in the decomposition temperature and deposits onto objects to be coated along with the carbon phase. There is no hard-and-fast rule for predicting what effect a given impurity will have. The properties of any doped cubic carbon coating must be determined on an impurity-by-impurity basis, but it is emphasized that such determination is well within the scope of this invention.

Thus by doping a cubic carbon coating with a predetermined amount and type of doping material, a coating having a pre-selected resistance may be achieved.

Further, it has been found that cubic carbon coated heat exchange elements are much more efficient than en element coated with some different substance such as black paint. Thus flowing a cool fluid such as water through a cubic carbon-coated coil will result in much greater energy absorption and heat transfer to the cool fluid than with other heat absorbing coatings operating simply on the principle of being a black surface.

Example 1 - Manufacture of cubic carbon.

A quartz tube having therein a divider separating it into upper and lower chambers and preheated to oven 900°C was flushed with helium (inert gases like N2 will function equally as well). The chamber was equipped as per figure 1, having heating elements to heat it evenly and a magnetic deflector to separate ions from decomposed gases. Various objects to be coated had been placed in the lower chamber including alumina crucibles, metal screws, and glass plates coated with alumina.

The ends of the upper chamber were sealed except for a small aperture at one end of the tube to which was attached a length of tubing which extended into a condenser with water to permit gas to escape from the ceramic tube without permitting atmosphere to re-enter therein.

A pinch valve was applied to the tubing to permit the aperture to be sealed off.

The heating elements were turned on and the temperature of the upper and lower chambers were raised to 900°C. Following this, high purity methane gas was allowed to enter the chamber and the temperature was maintained at 900°C for approximately 10 minutes until the methane had completely decomposed. The tube to the has trap was sealed with the valve and the chambers were allowed to cool to room temperature.

The objects which had been placed in the lower chamber were removed and examined and it was observed that a coating several hundred microns thick had been deposited upon all of the objects within the lower chamber. Using this procedure with more methane and longer exposure periods, coatings of several hundred microns have been deposited on various objects.

Example 2.

One end of the combustion tube, including both upper and lower chambers, was fitted with a quartz glass window. In this manner, it became possible to view the reaction and observe the deposition of the cubic carbon on the surface of the objects placed therein. As in Example 1, the opposite end of the chamber was sealed except for the pressure relief aperture which led to a dry ice trap which permitted the interior of the chamber to be isolated from the oxygen in the atmosphere.

A boat crucible containing a few drops of crude oil composed of both heavy and light hydrocarbon fractions was placed into the decomposition chamber and various metal and ceramic objects were placed throughout the lower chamber including immediately adjacent the quartz glass window.

0142176

The temperature was raised to approximately 1100°C and the process was observed through the quartz window.

At the elevated temperature the mixture of light and heavy crude was seen to decompose into two distinct layers of vapor within the upper chamber. The upper layer was believed to be composed of reducing hydrogen gases and the vapors of contaminants in the oil, such as sulfur. The lower layer was observed to be a heavy bluish-white cloud and was believed to be a stationary carbon ion cloud.

As long as any crude remained in the boat, material was produced which resolved into the two layers or zones. The evolution of these gases produced a positive pressure within the upper chamber such that the hydrogen continually flowed from the upper chamber into the dry ice trap. The gases in the upper zone flowed easily and exited the tube by way of the pressure relief aperture. The bottom layer, i.e. the carbon ion cloud, appeared to be much heavier and remained relatively stationary in the lower portion of the upper chamber, entering into the lower chamber through portholes.

Only those portions of the objects exposed to the carbon ion cloud were coated. Objects exposed to the upper chamber's vapors were not coated at all and lacked and deposited coating or metallic luster.

Example 3.

As in Example 2, crude oil containing varying percentages of lighter boiling fractions were examined. It was observed that the size of the vaporous cloud in the upper zone in the chamber was larger as the percentage of the light end fraction in the hydrocarbon was increased. It is noted that the lower carbon ion cloud was maintained as long as there was a positive flow of upper zone material leaving the exit aperture.

If desired, methane can be fed continually into the decomposition chamber to produce a positive flowing system wherein the upper fraction continually exits the upper chamber and is replenished by incoming new methane. In this manner te zone of carbon ions is sustained and cubic carbon is deposited in any desired quantity on the objects in the lower chamber. Vapor density is kept at the saturation level for best results.

A variety of materials and objects have been plated with the new crystalline carbon form in the manner detailed in the above examples. At present, cubic carbon has been found to deposit and tightly bond to quartz, ceramics, and metals with or without an oxide film. Further, deposition takes place regardless of the shape or size of the objects.

Example 4.

An aluminium crucible containing a specimen of hydrocarbon consisting of a very heavy crude oil was placed in an induction furnace which had been purged with an inert gas. The induction furnace was connected to one end of high density graphite decomposition tube three inches in diameter and six feet in length. A small aperture was provided at the opposite end of the graphite decomposition tube to which a gas trap was attached as previously described. Objects to be coated with cubic carbon were placed inside the graphite decomposition tube.

The induction furnace was raised to a temperature of 1100°C and the carbon ion vapor which evolved from the decomposition of the heavy crude oil was conducted from the induction furnace into the graphite decomposition tube to be deposited upon the objects therein. Thereafter, the temperature of the induction furnace was reduced and the objects were removed from the graphite decomposition tube.

Upon examination of the objects coated in this manner, it was observed that the coating on those objects within the combustion tube and nearest the induction coils was smooth, very bright and lustrous. The coating on objects were progressively less shiny and more dull and grey as the distance from the induction coils increased. On some objects a mixture of cubic carbon and needle crystalline carbon from graphite vapor was observed.

Observations of the many variations of the process of this invention as illustrated in the above example indicate that a vessel containing a carbonaceous material such as heaby crude oil or tar may be connected to the interior of a suitable furnace, such as an induction furnace, such as an induction furnace by an appropriate means such as a ceramic tube. The furnace may, in turn, be interconnected with a large chamber. If desired, the furnace could be located as a well or pit portion withint the larger chamber. Thereafter, the oxygen in the atmosphere of the furnace and chamber could be removed by purging the chamber and furnace with an inert gas such as N  or helium. The chamber could then be heated to a convenient temperature (above about 600°C) and the induction furnace portion could be heated to greater than 900°C, preferably about 1100°C, and as high as 2400°C.

With such an arrangement the carbonaceous material could be added dropwise continuously to the induction furnace portion and, therefore, the carbon ion cloud could be produced continuously. By this means, the cubic carbon could be deposited upon objects located within the chamber in whatever quantities might be desired.

Example 5.

The ceramic combustion tube of the previous examples was replaced with a quartz glass decomposition tube having an internal diameter of approximately 1-1/2 inches and a length of approximately 4 feet. The quartz glass decomposition tube was placed in the furnace such that the midpoint of the tube was within the furnace and the end portions of the quartz tube extended outside the furnace. Articles to be coated were placed inside the quartz tube and the ends of the quartz tube were sealed with laboratory stoppers.

A length of one-quarter inch OD quartz glass tubing was inserted through one rubber stopper at one end and plastic tubing was attached thereto. The other end of the plastic tubing was attached to a water air lock. As in the previous examples, positive pressure permitted the gas to escape but atmospheric oxygen was not permitted to re-enter.

The other end of the quartz decomposition tube contained a laboratory stopper with a length of one-quarter inch OD quartz glass tubing passing therethrough. A cylindrical alumina tube having one open end was placed over the end portion of the quartz glass tubing located within the decomposition chamber. Refractory wool was packed within the annulus between the alumina tube and the quartz glass tube to filter gases passing through the quartz tubing into the quartz decomposition chamber.

A length of plastic tubing was attached to the opposite end of the quartz glass tubing located on the exterior of the decomposition chamber. A hydrocarbon gas source comprising a bottle of natural gas with a needle valve was attached to the exterior end of the quartz tubing in a convenient manner. In this manner the hydrocarbon gas could pass from the gas source, in turn, into the length of quartz glass tubing, the annulus between by the ceramic tube and the quartz tubing continuing through the refractory wall filter, and into the quartz decomposition chamber. Thereafter, gas within the chamber could exit through the quartz tubing at the opposite end of the decomposition chamber and escape through the air lock.

The furnace was turned on and the temperature at the center portion of the quartz glass decomposition chamber was raised to approximately 1000°C. The hydrocarbon gas was introduced very slowly into the decomposition chamber and the gas was allowed to react with the oxygen within the chamber. After the oxygen in the chamber was exhausted, the hydrocarbon gas decomposed to deposit upon the substrates within the chamber a bright coating of cubic carbon.

It has been found that any hydrocarbon can be used in the process to produce cubic carbon. However, to procude a deposit of highest purity and with the least number of cubic carbon crystal discontinuities or defects, the choice of hydrocarbon and flow rate must be controlled. Using this process, crude oil, gasoline, benzene, alcohol, olefins, acetylene, aromatics and hydrocarbon gases such as methane, ethane, butane, etc. have been used with success.

In order to produce a high purity cubic carbon which is primarily single crystal sheet, it is extremely important that even a trace amount of contaminants such as oxygen or sulfur be kept out of the decomposition tube. It has been observed that alkanes of six carbon atoms or less produce cubic carbon coatings with the least crystal discontinuities. It is presently preferred to use high purity methane or oher lighter hydrocarbons as the carbon source for the process of the present invention.

Examples 6 to 10.

Using the same apparatus as described in Example 4 the decomposition chamber containing the desired substrate to be coated was heated to 1100°C. A volume of hydrocarbon gas or vapor was fed into the decomposition chamber within one minute and the temperature maintained for ten minutes. Thereafter, heating was terminated and the decomposition chamber was allowed to cool to room temperature and the substrate sample was discharged.

Using this procedure, two-dimensional single crystal sheets of cubic carbon were deposited on quartz glass using butane, ethylene, heptane, methane, benzene, acetone and crude oil. Table 1 following illustrates how the number of crystal discontinuities and impurities, as reflected by the specific resistance of the cubic carbon, are effected by the starting material.

TABLE 1

| Example Number | Starting Hydrocarbon | Volume Hydrocarbon | Specific Resistivity ohm/cm |
|---|---|---|---|
| 6 | Crude Oil | 1cc | 1000 |
| 7 | Benzene | 1cc | 300 |
| 8 | Acetone | 1cc | 150 |
| 9 | Butane | 100cc | 100 |
| 10 | Methane | 100cc | 50 |

Examples 11-13

An alumina substrate was placed in the decomposition chamber as described in the above examples, the furnace was heated to 1500°C and a volume of butane gas was injected into the decomposition chamber within approximately one minute. After ten minutes the chamber was cooled and the substrate discharged. Table 2 which follows illustrates the variation and specific resistance of the metallic carbon deposit as a function of carbon concentration.

TABLE 2

| Example Number | Hydrocarbon | Hydrocarbon Volume | Specific Resistivity ohm/cm |
|---|---|---|---|
| 11 | Butane | 100cc | 10 |
| 12 | Butane | 200cc | 2 |
| 13 | Butane | 1000cc | 0.2 |

Example 14.

In a series of tests a metal article was placed within a decomposition chamber and the chamber was purged with helium until all oxygen was removed. The decomposition chamber was heated to 1000°C and 200cc of butane gas was fed therein. At the end of thirty minutes, the decomposition chamber was cooled to room temperature and the metal article was removed. Using the procedure articles of tungsten, titanium, platinum, molybdenum, solicon, niobium, carbon steel and byrellium were coated with a metallic carbon layer rendering the metal article completely resistant to any corrosive gas or liquid and/or combinations thereof.

Upon examination, objects coated with cubic carbon have a bright cubic luster similar to chromium metal. The visual appearance varies depending upon the habit of the cubic carbon crystal. This crystal habit can be effected by the reaction temperature, flow rate of starting material, concentrate of carbon ions in the reaction atmosphere, impurities, vapor density, and the texture of the surface upon which the cubic carbon is deposited.

Example 15.

Ceramic crucibles which had been coated with cubic carbon were placed inside a furnace in the absence of air and elevated to a temperature of approximately 2400°C for several hours. Upon examination, the coating on the crucibles showed absolutely no sign of degradation.

The coated ceramic crucibles were placed inside a muffle furnace and elevated to 1100°C in the presence of oxygen. It was observed that the coating very slowly volatilized without evolution of smoke and vanished leaving no residue. At temperatures up to approximately 600°C and in the presence of air no visible degradation has been observed at the end of time spans as long as forty-eight hours.

Example 16.

Cubic carbon was found to vary from electrically conductive to semiconductive depending upon the relative purity and crystal continuity of the coating. One object coated in this manner was a small boat crucible composed of a smooth refractory ceramic. Using conventional electroplating methods, the crucible was connected to a terminal of a voltage source and electroplated with a layer of nickel metal.

Example 17.

Another object coated with the new cubic carbon was a small ceramic tube appromately two inches long and having an outside diameter of approximately one-quarter inch. Using standard methods, a band of nickel approximately one-quarter inch wide was electroplated at each end of the ceramic tube. The leads of a voltage source were attached respectively to each of the nickel bands.

Due to the thin coating of the semiconductive cubic carbon on the surface of the ceramic tube, the tubing acted as a resistor. An electric current was passed through the coating on the ceramic tube causing the temperature of the ceramic tube to rise until it glowed red. It was observed that as the temperature of the cubic carbon increased, its resistance decreased. That is, the cubic carbon exhibited a negative thermal coefficient of resistance. After this test, the coating on the ceramic tube was examined and no sign of oxidation or decomposition was observed by visual inspection and the material maintained its bright metallic luster.

Example 18.

By connecting an annameter across the leads of the tube of Example 17, a current of 50 microamps was generated upon heating the tube. Using this procedure heat can be converted to electricity at temperature as low as 130°F.

Example 19.

Tests were made for solubility or etchability in acetone, zylenes, isopropyl alcohol, sulfuric acid, hydrofluoric acid, hydrochloric acid, nitric and phosphoric acids. Tests were made using full strength reagents at room temperature. Samples were also boiled for periods ranging from hours to days, washed in de ionized water and then examined using scanning electron microscopy techniques to compare them with an untreated control. None of the solvents or acids had any noticeable effect.

Example 20.

Pieces of alumina tubing coating with a thin film of cubic carbon were exposed alternately to hot hydrofluoric, hydrochloric, and nitric acids for extended periods of time without observed corrosion or decomposition of the cubic carbon coating. Thereafter, the substrates coated with the cubic carbon were alternately exposed to hot sodium hydroxyde, potassium hydroxide, and ammonium hydroxide without any visible reaction. In fact, at the present time, no attempted combination of acid, base or organic compound has been shown to corrode an article coated with cubic carbon.

Example 21.

Tungsten carbide cutting tools have been coated with cubic carbon at a thickness of one micron with a consequent doubling of the life of the cutting edge.

Example 22.

A china cup was coated with cubic carbon and two electrical connections were made to the coating. The cup was filled with water and a power source of 25 watts was applied to the electrical connections. Within one minute the water was boiling in the cup.

Because of the unique properties as demonstrated by the above examples, cubic carbon is useful in the manufacture of an article which must resist corrosive environments at high temperatures. Further, the ability of the cubic carbon to be very strongly bonded or diffused to a surface such as ceramic and thereafter permit the surface to conduct electricity to permit the substrate to be electroplated in a conventional manner with a metal provides a method of permanently bonding an electrically conductive surface to a non-conducting ceramic.

Although only a few exemplary embodiments of this invention have been described in detail above, those skilled in the art will readily appreciate that many modifications are possible in the exemplary embodiments without materially departing from the novel teachings and advantages of this invention. Accordingly, all such modifications are intended to be included within the scope of this invention as defined in the following claims.

Claims.

1.- A process of adherently depositing a layer of crystalline carbon onto a substrate comprising :
a. causing hydrocarbon vapor to dissociate into carbon and hydrogen fractions; and
b. causing said carbon fraction to deposit onto said substrate as said crystalline carbon.

2.- The process of claim one wherein said crystalline carbon is characterized by the X-ray diffraction pattern of Figure 2.

3.- The process of claim 1 wherein said hydrocarbon vapor is selected from the group consisting of hydrocarbons having one to six carbon atoms.

4.- The process of claim 3 wherein said hydrocarbon vapor is methane.

5.- The process of claim 1 further comprising the step of doping said crystalline carbon by including an impurity in said hydrocarbon vapor.

6.- The process of claim 5 wherein said impurity is selected from the group consisting of metals, nitrogen, and sulphur.

7.- A process of adherently depositing a layer of crystalline carbon onto a substrate, comprising :
a) placing objects desired to be coated with said crystalline carbon into a chamber;
b) purging said chamber with an inert gas;
c) heating said chamber to a temperature of at least 600°C;
d) admitting hydrocarbon vapor to said purger chamber wherein said vapor decomposes into gaseous ionic hydrogen and carbon fractions; and

e) causing said ionic fractions to separate into a hydrogen layer and a carbon layer, said vapor being admitted such that no mass convection of said layers occurs, such that said carbon layer is exposed to said substrate whereon said carbon layer adherently deposits;

8.- A process of claim 7 wherein said hydrocarbon vapor is selected from hydrocarbons having 1 to 6 carbon atoms.

9.- The method of claim 7 further comprising the step of doping said crystalline carbon by including in the hydrocarbon vapor a known impurity of know concentration.

10.- The process of claim 7 further comprising doping said crystalline carbon by placing into said deposition chamber a known amount of a known impurity which vaporizes at the temperatures of decomposition.

11.- The process of claim 7 wherein said crystalline carbon is characterized by the X-ray diffractionpattern of Figure 2.

12.- A crystalline form of carbon defined by the X-ray diffraction pattern of Figure 2.

13.- A crystalline carbon produced by the process of claim 1.

14.- A substrate coated with a layer of crystalline carbon by the process of claim 1.

Fig.1

Fig.2

## Fig.3

## Fig.4

*Fig.5*

*Fig.6*

*Fig.7*

*Fig.8*

0142176

## Fig.9

1µm  ×25000  30kV  AMRAY

## Fig.10

10µm  ×5000  30kV  AMRAY

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | JETP LETTERS, vol.30 no.4, August 1979, NEW YORK (US) pages 199-202. N.MATYUSHENKO et al.:"A dence new version of crystalline carbon $C_8$". <br><br> * The whole document * <br><br> --- | 1 | C 23 C 16/26 /C 01 B 31/02 |
| A | FR-A-2 518 581 (BARR & STROUD LTD) <br><br> --- | | |
| A | SOVIET PHYSICS TECHNICAL PHYSICS vol.50, no.1, January 1980, NEW YORK (US) pages 103-105. E.ZORIN et al.:"Deposition of carbine and diamond-like films in the plasma of an rf gas discharge." <br><br> --- | | |
| | | | TECHNICAL FIELDS SEARCHED (Int. Cl.4) |
| A | GB-A-2 128 637 (TECHNION RESEARCH) <br><br> --- | | C 23 C 16/00 C 01 B 31/00 C 30 B 23/00 |
| A | THIN SOLID FILMS, vol.58, 1979, pages 117-120, Elsevier Sequoia S.A. LAUSANNE (CH) S.BERG et al.:"Diamond-like carbon films produced in a butane plasma." <br><br> --- <br><br> -/- | | |

The present search report has been drawn up for all claims

| Place of search | Date of completion of the search | Examiner |
|---|---|---|
| THE HAGUE | 12-02-1985 | DEVISME F. |

European Patent
Office

**EUROPEAN SEARCH REPORT**

Application number

EP 84 20 0311

Page 2

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (Int Cl 4) |
| A | THIN SOLID FILMS vol.96, no.1, October 1982, LAUSANNE(CH) C. WEISSMANTEL et al.:"Preparation and properties of hard i-C and i-BN coatings." | | |
| | --- | | |
| A | PATENTS ABSTRACTS OF JAPAN, vol.7, no.277, December 9, 1983 (C-199) (1422) <br><br> & JP-A-58 156 512 (SHIN NIPPON SEITETSU K.K) 17-09-1983 | 6 | |
| | --- | | |
| A | FR-A-2 074 398 (KUREHA KAGAKU KOGYO K.K) | 7 | |
| | --- | | TECHNICAL FIELDS SEARCHED (Int Cl 4) |
| A | US-A-4 410 504 (F.GALASSO et al.) <br><br> * Column 3, line 22 * | 7 | |
| | --- | | |
| A | WO-A-81 03 669 (ESTABLISHMENT FOR SCIENCE AND TECHNOLOGY ) | 7 | |
| | --- | | |
| A | FR-A-1 238 079 (K.OKURA) | 7 | |
| | ----- | | |

The present search report has been drawn up for all claims

| Place of search | Date of completion of the search | Examiner |
|---|---|---|
| THE HAGUE | 12-02-1985 | DEVISME F. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82